# EUROPEAN PATENT SPECIFICATION

(11) **EP 2 546 730 B1**
(45) Date of publication and mention of the grant of the patent: **01.04.2020**
(21) Application number: 12176155.5
(22) Date of filing: 12.07.2012
(51) Int. Cl.: G06F 3/041, H03K 17/955, H03K 17/96, H03K 17/975

(54) **Combined force and proximity sensing**
Kombinierte Kraft- und Näherungsmessung
Détection de proximité et de force combinée

(30) Priority: 14.07.2011 US 201113183371
(43) Date of publication of application: 16.01.2013
(73) Proprietor: Apple Inc., Cupertino CA 95014 (US)
(72) Inventor: Grunthaner, Martin Paul, Cupertino, CA, 95014 (US); Rothkopf, Fletcher R., Cupertino, 95014 (US); Mullens, Christopher Tenzin, Cupertino, CA, 94014 (US); Hotelling, Steven Porter, Cupertino, CA, 95014 (US); O'Connor, Sean Erik, Cupertino, 95014 (US)
(74) Representative: Lang, Johannes

(56) References cited:
- EP-A2- 1 811 364
- WO-A2-2008/009687
- US-A1- 2010 128 002
- US-A1- 2011 141 052

## Description

### Field

This relates generally to input sensing and more particularly to input sensing using combined force and proximity sensing.

### Background

One of the most common input mechanisms in a consumer product device is a button, which when contacted by a user causes the device to change a state associated with the button. Pressing or selecting the button can activate or deactivate some state of the device and cause an associated action to be performed. Not pressing or selecting the button can leave the device in its current state with no associated action being performed. The traditional button has been the mechanical push button, such as keys, knobs, and the like, that can be activated or deactivated by a force applied to the button that is detected by a mechanical switch, force sensor, or the like. While accidental activations do happen, they are infrequent because of the amount of force required. With the advent of touch technology, the virtual button, such as a graphical user interface input area displayed on a touch sensitive display, has become very popular and can be activated or deactivated by a touch at the button that is detected by a proximity sensor. However, because a virtual button requires little or no force to activate, accidental activations are more frequent, causing unintended and sometimes damaging action to be performed on the device.

Therefore, in order for a button to operate properly, it is important that the button's input to the device be interpreted correctly to indicate that the button has been intentionally activated.

WO 2008 / 009687 A2 discloses an input device is provided with a film-based pressure sensor build from a first carrier film, a second carrier film and a spacer arranged between the carrier films for keeping them at a distance from one another. A control circuit able to operate in at least a first and a second mode of operation is configured so as to measure, in the first mode of operation, a quantity indicative of electrical resistance between the first and second electrodes for detecting an amount or a position of a compressive force acting on the active zone and, in the second mode of operation, a quantity indicative of a capacitance for detecting a person or an object approaching thereto.

EP 1 811 364 A2 discloses a flexible circuit having capacitive means for proximity sensing and resistive means for pressure sensing.

### Statement of Invention

The present invention is defined by the features of the independent claims. Preferred advantageous embodiments thereof are defined by the sub-features of the dependent claims.

Any reference to "embodiment(s)", "example(s)" or "aspect(s) of the invention" in this description not falling under the scope of the claims should be interpreted as illustrative example(s) for understanding the invention.

### Summary

This relates to combined force and proximity sensing, in which one or more sensors can concurrently sense a force applied by an object on a surface and a proximity of the object to the surface. In an example, a single sensor can sense both force and proximity via a resistance change and a capacitance change, respectively, at the sensor. In another example, one sensor can sense force via either a resistance change or a capacitance change and another sensor can sense proximity via a capacitance change. Combined force and proximity sensing can be used with a device's input mechanism, e.g., a virtual button. By sensing both force and proximity of an object at the input mechanism before the device changes state and performs an associated action, combined force and proximity sensing can advantageously increase detection of intended contact on a device and decrease detection of accidental contact on the device.

### Brief Description of the Drawings

FIG. 1 illustrates an exemplary sensing device having a combined force and proximity sensor according to various examples.
FIGs. 2A through 2E illustrate an exemplary force sensor according to various examples.
FIG. 3 illustrates an exemplary sensing device having a force sensor and a proximity sensor according to various examples.
FIG. 4 illustrates another exemplary sensing device having a force sensor and a proximity sensor according to various examples.
FIGs. 5A through 5D illustrate an exemplary proximity sensor according to various examples.
FIGs. 5E through 5H illustrate another exemplary force sensor according to various examples.
FIG. 6 illustrates another exemplary sensing device having a combined force and proximity sensor according to various examples.
FIG. 7 illustrates an exemplary sensing device having a flexible circuit and a rigid conductive member to provide a proximity sensor and a force sensor according to various examples.
FIG. 8 illustrates an exemplary sensing device having a flexible circuit and a compliant conductive member to provide a proximity sensor and a force sensor according to various examples.
FIG. 9 illustrates an exemplary sensing device having a sealing element applied thereto according to various examples.
FIG. 10 illustrates an exemplary sensing device having a flexible circuit and a capacitive electrode to provide a proximity sensor and a force sensor according to various examples.
FIG. 11 illustrates another exemplary sensing device having a flexible circuit and a capacitive electrode to provide a proximity sensor and a force sensor according to various examples.
FIG. 12 illustrates an exemplary sensing device having a double flexible circuit to provide a proximity sensor and a force sensor according to various examples.
FIG. 13 illustrates an exemplary display device having multiple force sensors disposed around the device perimeter according to various examples.
FIG. 14 illustrates an exemplary sensing device having a dimple in a surface and capacitive electrodes proximate thereto to provide a combined force and proximity sensor according to various examples.
FIG. 15 illustrates an exemplary sensing device having multiple force sensors with a first sensor configured to sense force and the other sensors configured to sense noise.
FIG. 16 illustrates an exemplary method for sensing combined force and proximity at a device according to various examples.
FIG. 17 illustrates an exemplary computing system for sensing combined force and proximity according to various examples.
FIG. 18 illustrates an exemplary mobile telephone having combined force and proximity sensing capabilities according to various examples.
FIG. 19 illustrates an exemplary digital media player having combined force and proximity sensing capabilities according to various examples.
FIG. 20 illustrates an exemplary personal computer having combined force and proximity sensing capabilities according to various examples.

### Detailed Description

In the following description of examples, reference is made to the accompanying drawings in which it is shown by way of illustration specific examples that can be practiced. It is to be understood that other examples can be used and structural changes can be made without departing from the scope of the various examples.

This relates to combined force and proximity sensing, in which one or more sensors can concurrently sense a force applied by an object on a surface and a proximity of the object to the surface. In some examples, a single sensor can sense both force and proximity together via a resistance change and a capacitance change, respectively, at the sensor. In some examples, multiple sensors can be used concurrently, where one sensor can sense force via either a resistance change or a capacitance change and another sensor can sense proximity via a capacitance change. This can advantageously prevent a device from changing state and performing an associated action unless both force and proximity of an object have been concurrently detected.

Although some examples are described herein in terms of resistive and capacitive sensors to detect force and proximity, it is to be understood that other types of sensors can be used according to various examples.

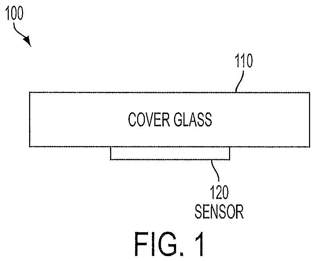

FIG. 1 illustrates an exemplary sensing device having a combined force and proximity sensor according to various examples. In the example of FIG. 1, sensing device 100 can include a cover glass 110 having a touchable surface that an object can hover over, touch, or press on. The device 100 can also include combined force and proximity sensor 120 disposed on a surface of the cover glass 110 opposite the touchable surface, although in other examples the sensor 120 may be supported on another substrate adjacent to the cover glass. The sensor 120 can sense the force applied by an object pushing on the touchable surface and the proximity of the object to the surface. In some examples, the sensor 120 can be a hybrid resistive-capacitive sensor, such as a force sensitive resistor. In some examples, the cover 110 can be glass, plastic, or any suitable material capable of providing a substantially rigid substrate having a touchable surface.

The sensor 120 can be coupled to a voltage supply (not shown) to drive the sensor to detect the force applied, the object proximity, or both. The sensor 120 can output a sensing signal indicative of the detected force or proximity to a sensing circuit (not shown) for processing.

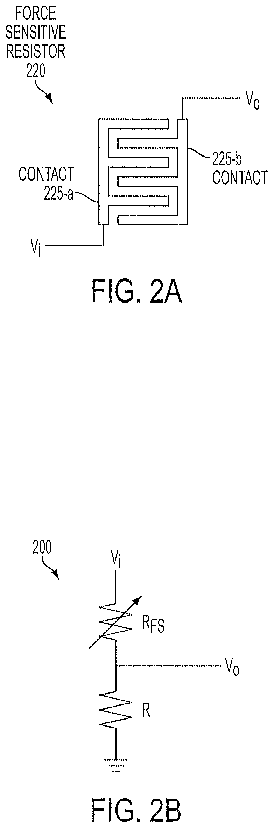

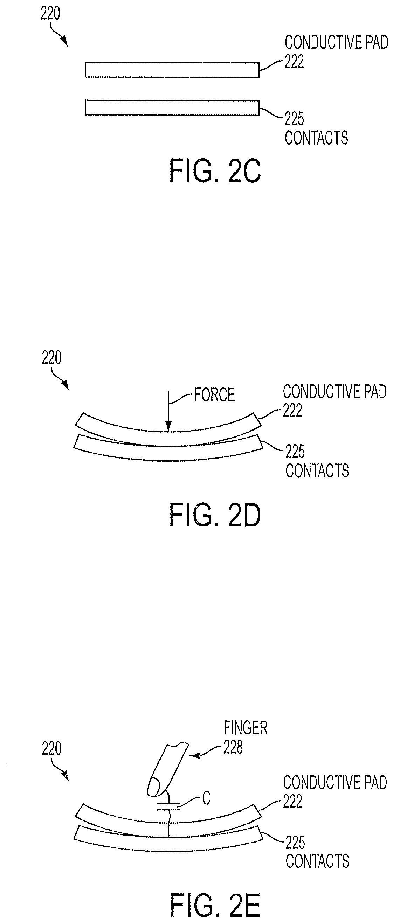

FIGs. 2A through 2E illustrate an exemplary force sensor that can be used in the sensing device of FIG. 1 to detect force and proximity of an object. FIG. 2A illustrates a top view of the force sensor, which in this case can be a force sensitive resistor. In the example of FIG. 2A, force sensitive resistor 220 can include two interleaved contacts 225-a, 225-b positioned closely together, but not touching, while at rest, although it should be understood that other contact configurations can also be employed. Contact 225-a can be coupled to a voltage supply to receive voltage Vi. Contact 225-b can be coupled to a voltage output to transmit voltage Vo. As shown in FIG. 2C, the resistor 220 can also include conductive pad 222 covering, but not touching the contacts 225, while at rest. With no force applied, i.e., while at rest, the resistor 220 can look like an infinite resistor (an open circuit). The resistor 220 can be positioned under the cover glass 110 at a location where force is to be applied.

When force is applied to the cover glass 110, as in FIG. 2D, the cover glass can bow, causing the conductive pad 222 to similarly bow and push against the contacts 225. The conductive pad 222 can form a conductive bridge between the contacts 225-a, 225-b to allow current supplied by voltage Vi to flow through the resistor 220. As a result, the resistance in the resistor 220 can be reduced. As the force being applied increases, the resistance can correspondingly decrease. Thus, when a sensing circuit of the sensing device 100 detects a drop in resistance of the resistor 220, the drop can be interpreted as a force being applied to the cover glass 110. A baseline resistance can be established when the resistor 220 is at rest (i.e., the contacts are in an equilibrium state) and can be compared to the resistance when force is applied in order to determine the drop. In the example of FIG. 2B, voltage divider 200 can be used to detect the resistance drop of the resistor 220. The divider 200 can include the resistor 220 (illustrated as Rfs) having voltage input Vi and coupled to another resistor (illustrated as R). The divider 200 can output voltage Vo as an indication of the resistance drop.

Concurrently therewith, a proximity of the object applying the force can be detected. The resistor 220 can act as a self capacitive sensor with a capacitance to ground. As shown in FIG. 2E, when the object, e.g., finger 228, is proximate to the cover glass 110, the resistor 220 can capacitively couple to ground through the object, causing charge to be shunted from the resistor to the object. As a result, the self-capacitance at the resistor 220 can be increased. As the object gets closer to the cover glass 110, the amount of shunted charge can continue to increase and the self-capacitance can continue to increase. Thus, when a sensing circuit of the sensing device 100 detects an increase in self-capacitance at the resistor 220, the increase can be interpreted as an object being proximate to the cover glass 110. A baseline capacitance can be established when there are no objects proximate to the resistor 220 and can be compared to the capacitance when the object is proximate in order to determine the increase. In some examples, an additional conductive element can be positioned proximate to the resistor 220 to form a mutual capacitive sensor with the resistor. The mutual capacitance drop between the two can then be detected to determine object proximity.

In response to the object force and proximity, an action can be performed by a computing device operating the sensing device. In some examples, an action can be triggered just by the indication of force and proximity. In some examples, the triggered action can be a function of how much force is applied to the sensing device, i.e., based on the magnitudes of the resistance drop and the capacitance change (increase for self-capacitance examples, drop for mutual capacitance examples). For example, a light force can trigger one action, while a heavier force can trigger a different action. In some examples, the triggered action can be a function of the sequence of presses on the sensing device. For example, two presses in rapid succession can trigger one action, while three presses can trigger another action. Other types of applied forces are also possible according to the requirements of the sensing device.

In some examples, the resistor 220 can have two sets of traces, one set to transmit resistance data to the sensing circuit and another set to transmit capacitance data to the circuit. In some examples, the resistor 220 can have one set of traces and a switching mechanism to switch between a resistance mode for transmitting resistance data along the traces to the sensing circuit and a capacitance mode for transmitting capacitance data along the traces to the circuit. These trace configurations can be used with other sensing devices described herein that have a combined force and proximity sensor. In some examples, the sensing circuit can be a processor.

The sensor 120 can be attached to the cover glass 110 in any number of ways. For example, the sensor 120 can be glued, sputtered, printed, etched, chemically deposited, or otherwise attached to the cover glass 110. In other examples, the sensor 120 can be attached to a different substrate in a similar manner. The traces from the sensor 120 to the sensing circuit can similarly be attached to the cover glass 110 and other device components in route to the sensing circuit.

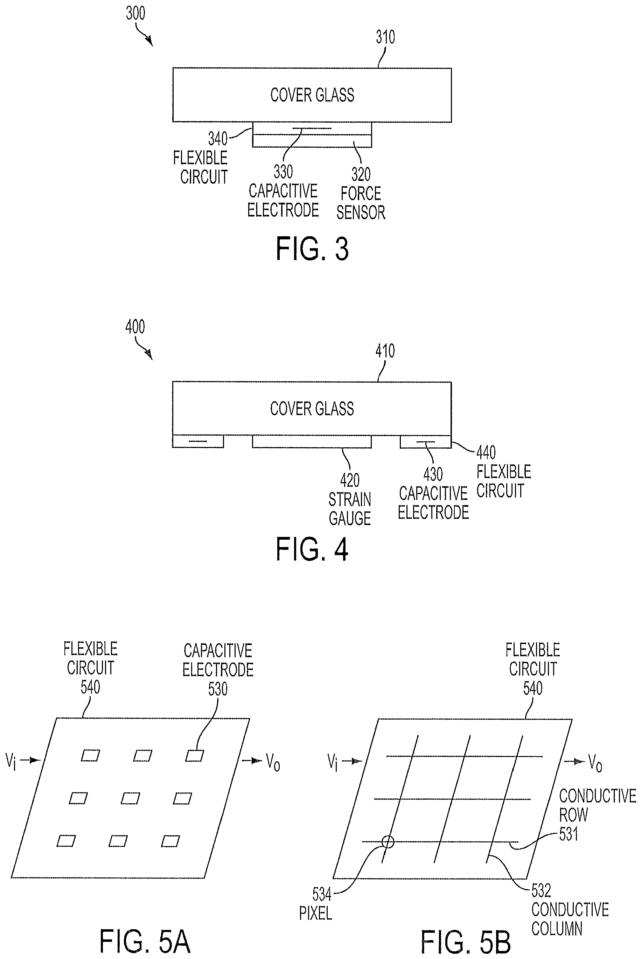

FIG. 3 illustrates an exemplary sensing device having a force sensor and a proximity sensor according to various examples. In the example of FIG. 3, sensing device 300 can include cover glass 310, like that of FIG. 1. The device 300 can also include flexible circuit 340 having one or more capacitive electrodes 330 embedded therein and disposed on a surface of the cover glass 310 opposite the touchable surface. Although in other examples, the flexible circuit 340 can be supported on another substrate adjacent to the cover glass 310. The capacitive electrode 330 in the flexible circuit 340 can act as a proximity sensor. The device 300 can also include force sensitive resistor 320 stacked onto the flexible circuit 340 to act as a force sensor. The flexible circuit 340 can be any flexible substrate suitable for having one or more elements disposed on or embedded in the circuit for sensing and transmitting data to a sensing circuit.

FIGs. 5A through 5D illustrate an exemplary proximity sensor that can be used in the sensing device of FIG. 3 to detect proximity of an object. FIG. 5A illustrates a top view of proximity sensors, which in this case can be self capacitive. In the example of FIG. 5A, flexible circuit 540 can have capacitive electrodes 520 embedded therein. The capacitive electrodes 520 can be based on self capacitance. In a self capacitive sensor, the self capacitance of the electrodes 520 can be measured relative to some reference, e.g., ground. The electrodes 520 can be spatially separated elements, where each electrode can define a proximity sensor. The electrodes 520 can be coupled to a driving circuit (not shown) to drive the electrodes to detect the object proximity and to a sensing circuit (not shown) to process signals indicative of the proximity.

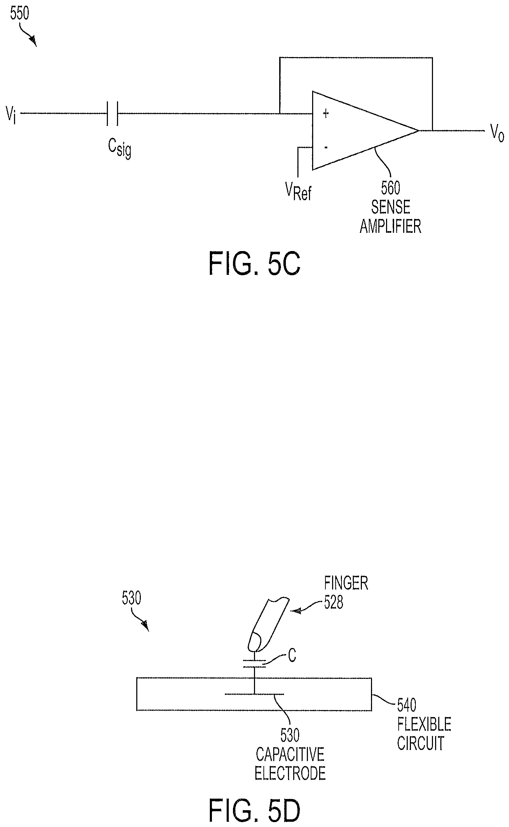

When the object is proximate to the cover glass 310, as in FIG. 5D, the electrode 530 can capacitively couple to ground through the object, e.g., finger 528, causing charge to be shunted from the electrode to the object. This can increase the self-capacitance at the electrode. As the object gets closer to the cover glass 310, the amount of shunted charge can continue to increase and the self-capacitance can correspondingly increase. Thus, when a sensing circuit of the sensing device 400 detects an increase in the self-capacitance of the electrode 530, the increase can be interpreted as an object being proximate to the cover glass 310. A baseline capacitance can be established when there are no objects proximate to the electrode 530 and can be compared to the capacitance when the object is proximate in order to determine the increase. In the example of FIG. 5C, circuit 550 can be used in mutual capacitance examples to detect the capacitance drop at a mutual capacitance pixel or electrode. The circuit 550 can include a drive circuit (not shown) to provide drive voltage Vi to the mutual capacitive electrode (illustrated as Csig). The circuit 550 can also include sense amplifier 560 to receive and process the capacitance signal indicative of the object proximity and to output voltage Vo.

FIG. 5B illustrates a top view of alternative proximity sensors, which in this case can be mutually capacitive. In the example of FIG. 5B, flexible circuit 540 can have conductive rows 531 and columns 532 forming spatially separated drive and sense lines, respectively. Here, the conductive rows 531 and columns 532 can cross each other to form pixels 534 at the cross locations, where each pixel can define a proximity sensor. Other configurations of the drive and sense lines are also possible, such as side by side. The conductive rows 531 can be coupled to a driving circuit (not shown) to drive the rows and the conductive columns 532 to a sensing circuit (not shown) to process signals indicative of the object proximity.

Referring again to FIG. 3, the resistor 320 can detect force applied by an object to the cover glass 310 in the same manner as described previously in FIG. 2. Concurrently therewith, the electrode 330 can detect the proximity of the object applying force to the cover glass 310 via a capacitance change, as described in FIGs. 5A through 5D.

In some examples, the electrode 330 and the resistor 320 can have separate sets of traces to the sensing circuit. In some examples, the separate sets of traces can be input to a switching mechanism, which can then connect to the sensing circuit through one set of traces and can switch between the electrode and resistor input traces. These trace configurations can be used with other sensing devices described herein that have separate force and proximity sensors.

In an alternate example, the sensing device 300 can include a spring material stacked onto the resistor 320 to exert a force against the resistor proportional to the bowing of the resistor, measured via the drop in resistance. The spring material can help the resistor 320 return to rest.

FIG. 4 illustrates another exemplary sensing device having a force sensor and a proximity sensor according to various examples. In the example of FIG. 4, sensing device 400 can include cover glass 410, like that of FIG. 1. The device 400 can also include strain gauge 420 disposed on a surface of the cover glass 410 opposite the touchable surface to act as a force sensor, although in other examples the strain gauge 420 can be supported on another substrate adjacent to the cover glass 410. The gauge 420 can be positioned under a cover glass location where force will be applied. The device 400 can also include flexible circuit 440, having capacitive electrode 430 embedded therein, disposed on the surface of the cover glass 410 opposite the touchable surface. The capacitive electrode 430 can act as a proximity sensor. The flexible circuit 440 can be positioned side by side with the gauge 420, or in other orientations.

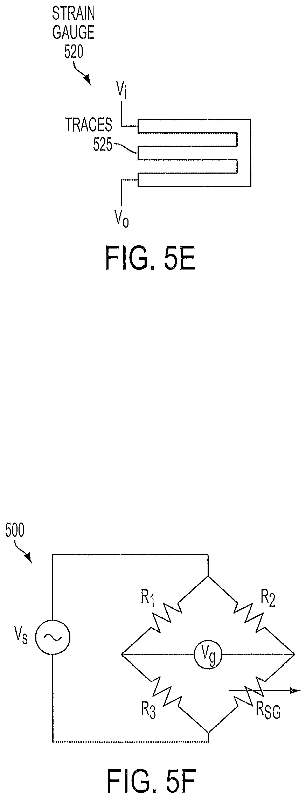

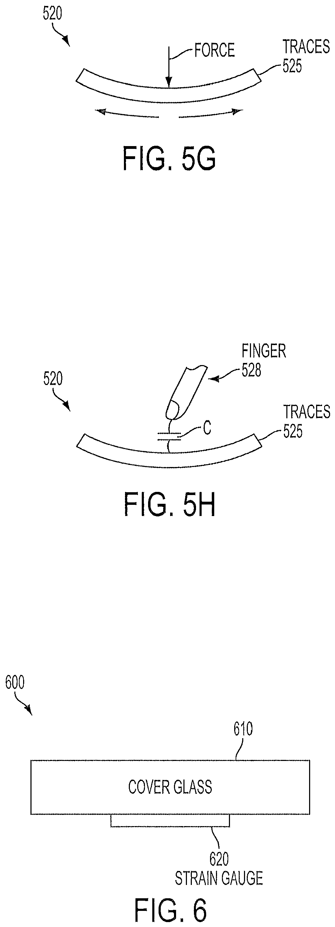

FIGs. 5E through 5H illustrate an exemplary force sensor that can be used in the sensing device of FIG. 4 to detect force applied by an object. FIG. 5E illustrates a top view of the force sensor, which in this case can be a strain gauge. In the example of FIG. 5E, strain gauge 520 can include traces 525 positioned closely together, but not touching, while at rest. The gauge 520 can be coupled to a voltage supply to receive voltage Vi and to a voltage output to transmit voltage Vo. When force is applied to the cover glass 410 under which the gauge 520 is disposed, as in FIG. 5G, the cover glass can bow, causing the traces 525 to stretch and become longer and narrower, thereby increasing the gauge resistance. As the force being applied increases, the gauge resistance can correspondingly increase. Thus, when a sensing circuit of the sensing device 400 detects a rise in resistance of the gauge 520, the rise can be interpreted as a force being applied to the cover glass 410. A baseline resistance can be established when the gauge 520 is at rest and can be compared to the resistance when force is applied in order to determine the rise. In the example of FIG. 5F, bridge 500 can be used to detect the resistance increase of the gauge 520. The bridge 500 can include the gauge 520 (illustrated as Rsg) and three other resistors (illustrated as R1, R2, R3). The bridge 500 can also include a meter to detect the current flow provided by Vg to help determine the resistance increase in the gauge 520.

Referring again to FIG. 4, concurrently, the electrode 430 in the flexible circuit 440 can detect the proximity of the object applying force to the cover glass 410 via a capacitance change in the same manner as the electrode of FIG. 3, and the gauge 420 can detect the force applied via a resistance change, as described in FIGs. 5E through 5G.

FIG. 6 illustrates another exemplary sensing device having a combined force and proximity sensor according to various examples. The sensing device of FIG. 6 can be the same as the sensing device of FIG. 1, except strain gauge 620 in FIG. 6 can replace force sensor 120 in FIG. 1. The strain gauge 620 can detect force applied to cover glass 610 in the same manner as in FIG. 5. Concurrently therewith, the gauge 620 can detect the proximity of the object, e.g., finger 528, applying force to the cover glass 610, as shown in FIG. 5H. That is, when the object is proximate to the cover glass 610, the gauge 620 can capacitively couple to the object, causing charge to be shunted from the gauge to the object, thereby increasing the gauge self-capacitance. As the object gets closer to the cover glass 610, the amount of shunted charge can continue to increase and the gauge capacitance to correspondingly increase. Thus, when a sensing circuit of the sensing device 600 detects an increase in the self-capacitance of the gauge 620, the increase can be interpreted as an object being proximate to the cover glass 610. A baseline capacitance can be established when there are no objects proximate to the gauge 620 and can be compared to the capacitance when the object is proximate in order to determine the increase.

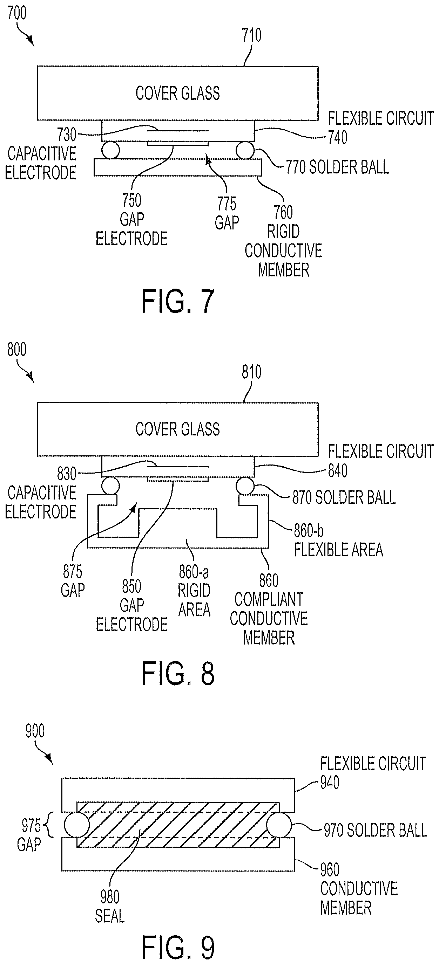

FIG. 7 illustrates an exemplary sensing device having a flexible circuit and a substantially rigid conductive member to provide a force sensor and a proximity sensor according to various examples. In the example of FIG. 7, sensing device 700 can include cover glass 710, like that of FIG. 1. The device 700 can also include flexible circuit 740, having capacitive electrode 730 embedded therein, disposed on a surface of the cover glass 710 opposite the touchable surface of the cover glass. The capacitive electrode 730 can act as a proximity sensor. The device 700 can also include gap electrode 750 disposed on a surface of the flexible circuit 740 opposite the surface proximate to the cover glass 710. The gap electrode 750 can be a capacitive electrode and can form the first element of a force sensor. The device 700 can include a substantially rigid conductive member 760 coupled to the flexible circuit 740 via solder balls 770 to form the second element of the force sensor. The member 760 can be metal or any other suitable conductive material. Other spacer elements, rather than the solder balls 770, can be used to couple the member 760 to the circuit 740. The spacer elements can be either rigid or deformable according to the sensing device requirements. Gap 775 can be formed between the member 760 and the circuit 740. In some examples, the gap can be filled with air. In some examples, the gap can be filled with dielectric material to improve the gain of the force signal.

When force is applied to the cover glass 710, the cover glass can bow, causing the flexible circuit 740 to bow as well to close the gap 775 between the gap electrode 750 and the member 760. This can result in increased capacitance between the electrode 750 and the member 760. As the force being applied increases, the gap electrode-rigid member capacitance can also increase. Thus, when a sensing circuit of the sensing device 700 detects a rise in capacitance between them, the rise can be interpreted as a force being applied to the cover glass 710. A baseline capacitance can be established when the gap is at a maximum between the gap electrode 750 and the rigid member 760 and can be compared to the capacitance when force is applied in order to determine the rise.

Concurrently therewith, the capacitive electrode 730 can detect the proximity of the object applying the force via a capacitance change in the same manner as the electrode of FIG. 3.

FIG. 8 illustrates an exemplary sensing device having a flexible circuit and a compliant conductive member to provide a force sensor and a proximity sensor according to various examples. The sensing device 800 of FIG. 8 can be the same as the sensing device 700 of FIG. 7, except compliant conductive member 860 in FIG. 8 can replace rigid conductive member 760 of FIG. 7. In the example of FIG. 8, the compliant conductive member 860 can have rigid area 860-a disposed directly below gap electrode 850 and flexible areas 860-b at the solder balls 870. This configuration can advantageously keep the rigid area 860-a of the member 860 more firmly in place when force is applied to the cover glass 810, thereby improving accuracy of the force-indicating capacitance data.

As stated previously, a gap can be formed between the flexible circuit and the conductive member, as in FIGs. 7, 8. A seal can be placed over the gap to prevent outside moisture from getting in to corrode the components and, in the case of dielectric material in the gap, to prevent the material from leaking out. FIG. 9 illustrates an exemplary sealant element of the sensing device according to various examples. In the example of FIG. 9, the open edges of the flexible circuit 940 and the conductive member 960 can be passivated with sealant 980 to seal the openings. In some examples, the sealant 980 can also be applied to the solder balls 970 to seal any weak areas. The sealant 960 can be silicone or any other suitable material.

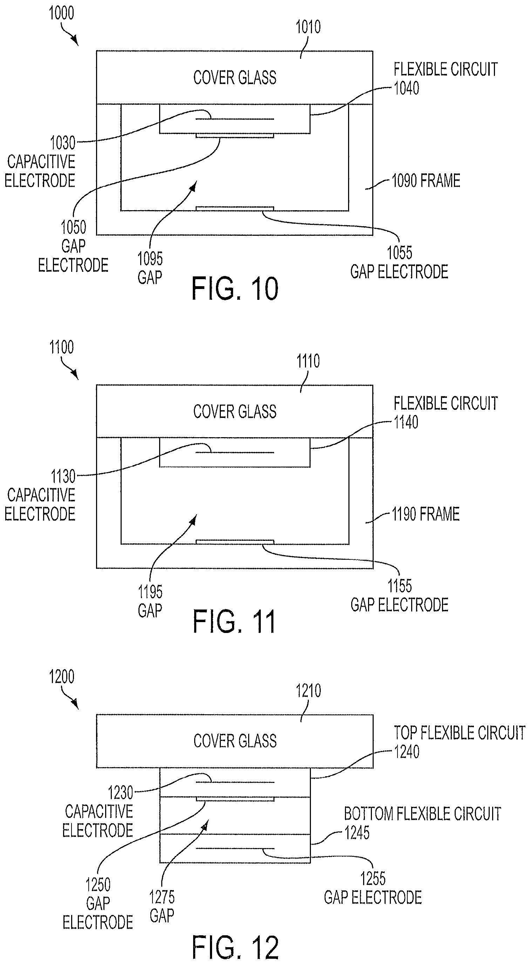

FIG. 10 illustrates an exemplary sensing device having a flexible circuit and a capacitive electrode to provide a force sensor and a proximity sensor according to various examples. In the example of FIG. 10, sensing device 1000 can include cover glass 1010, like that of FIG. 1. The device 1000 can also include flexible circuit 1040, having capacitive electrode 1030 embedded therein and gap electrode 1050 disposed thereon, like the flexible circuit of FIG. 7. The device 1000 can further include frame 1090 to seat the cover glass 1010 and to support second gap electrode 1055 that forms the second element of the force sensor (the first element being gap electrode 1050). The second gap electrode 1055 can, in some examples, be disposed directly beneath the other gap electrode 1050 and can similarly be a capacitive electrode. Gap 1095 can be formed between the two gap electrodes 1050, 1055.

When force is applied to the cover glass 1010, the cover glass can bow, causing the flexible circuit 1040 to bow as well to close the gap 1095 between the two gap electrodes 1050, 1055, thereby increasing the capacitance therebetween. As the force being applied increases, the gap electrode capacitance can also increase. Thus, when a sensing circuit of the sensing device 1000 detects a rise in capacitance between them, the rise can be interpreted as a force being applied to the cover glass 1010. A baseline capacitance can be established when the gap is at a maximum between the two gap electrodes 1050, 1055 and can be compared to the capacitance when force is applied in order to determine the rise.

Concurrently therewith, the capacitive electrode 1030 can detect the proximity of the object applying the force via a capacitance change in the same manner as the electrode of FIG. 3.

FIG. 11 illustrates another exemplary sensing device having a flexible circuit and a capacitive electrode to provide a force sensor and a proximity sensor according to various examples. The sensing device 1100 of FIG. 11 can be the same as the sensing device 1000 of FIG. 10, except single capacitive electrode 1130 of FIG. 11 can replace the capacitive electrode 1020 and the gap electrode 1050 in FIG. 10. Hence, in FIG. 11, the single capacitive electrode 1130 can act as a proximity sensor and as a first element of a force sensor, while second gap electrode 1150 can act as the second element of the force sensor.

When force is applied to the cover glass 1110, the cover glass can bow, causing the flexible circuit 1140 to bow also to close the gap 1195 between the capacitive electrode 1130 and the gap electrode 1155. As a result, the capacitance between the two electrodes 1130, 1155 can increase. As the force being applied increases, the capacitance can correspondingly increase. Thus, when a sensing circuit of the sensing device 1100 detects a rise in capacitance between the two electrodes 1130, 1155, the rise can be interpreted as a force being applied to the cover glass 1110. A baseline capacitance can be established when the gap is at a maximum between the two electrodes 1130, 1155 and can be compared to the capacitance when force is applied in order to determine the rise.

Concurrently therewith, the capacitive electrode 1130 can detect the proximity of the object applying the force via a capacitance change in the same manner as the electrode of FIG. 3.

FIG. 12 illustrates an exemplary sensing device having a double flexible circuit to provide a force sensor and a proximity sensor according to various examples. In the example of FIG. 12, sensing device 1200 can have cover glass 1210, like that of FIG. 1. The device 1200 can also have a double flexible circuit disposed on a surface of the cover glass 1210 opposite the touchable surface of the cover glass. The double flexible circuit can have top flexible circuit 1240 and bottom flexible circuit 1245. The top circuit 1240 can have capacitive electrode 1230 embedded therein to form a proximity sensor and first gap electrode 1250 disposed thereon and facing the bottom circuit 1245 to form a first element of a force sensor. The bottom circuit 1245 can have second gap electrode 1255 embedded therein and positioned directly below the first gap electrode 1250 to form the second element of the force sensor. To prevent the bottom circuit 1245 from bowing when force is applied to the device 1200, the bottom circuit can be laminated with a stiffener to make it substantially rigid. The gap electrodes 1250, 1255 can be capacitive electrodes. Gap 1275 can be formed between the top and bottom circuits 1240, 1245. In some examples, the gap can be filled with air. In some examples, the gap can be filled with a dielectric material.

When force is applied to the cover glass 1210, the cover glass can bow, causing the flexible circuit 1240 to bow also to close the gap 1275 between the two gap electrodes 1250, 1255. This can result in an increase in capacitance between the two electrodes 1250, 1255. As the force being applied increases, the gap capacitance can also increase. Thus, when a sensing circuit of the sensing device 1200 detects a rise in capacitance between the two gap electrodes 1250, 1255, the rise can be interpreted as a force being applied to the cover glass 1210. A baseline capacitance can be established when the gap is at a maximum between the two gap electrodes 1250, 1255 and can be compared to the capacitance when force is applied in order to determine the rise.

Concurrently therewith, the capacitive electrode 1230 can detect the proximity of the object applying the force via a capacitance change in the same manner as the electrode of FIG. 3.

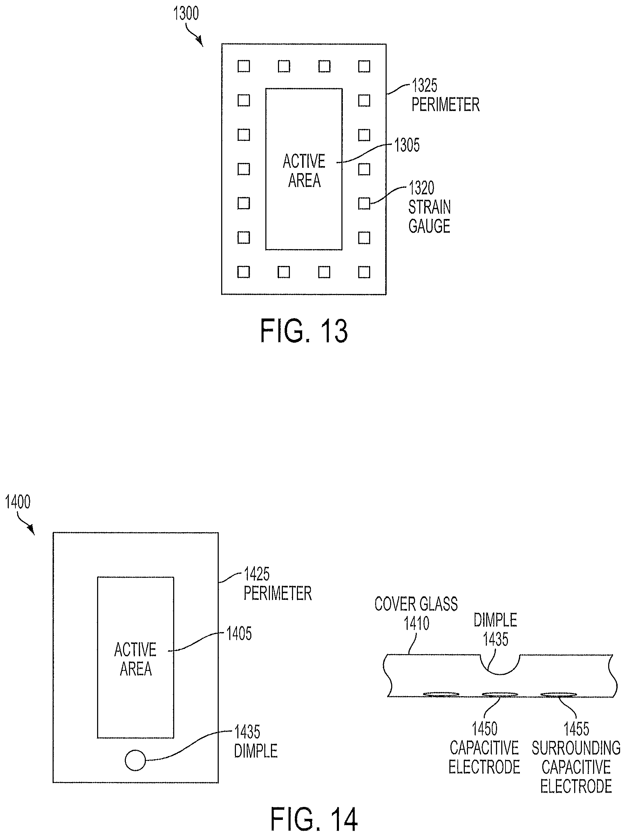

Force can be applied to either a limited area of the sensing device's cover glass, such as at a designated button or dimple, or at multiple areas of the cover glass, depending on the requirements of the device. FIG. 13 illustrates an exemplary display device having multiple force sensors disposed around the device perimeter, where force can be applied to multiple areas of the device. In the example of FIG. 13, display device 1300 can include active area 1205 for displaying graphical data and/or receiving touch inputs in accordance with the displayed data. The device 1300 can also include perimeter 1325 with multiple force sensors 1320 positioned around the perimeter. As such, force can be applied to any one or more areas around the device perimeter 1325 to cause certain actions to occur according to the location(s), the number of locations simultaneously pressed, or the sequence of the locations pressed. In addition, because the sensors 1320 circle the entire perimeter 1325, they can form a grid over the entire display cover glass to detect force applied at any area on the surface, including in the active area 1305.

FIG. 14 illustrates an exemplary display device having a dimple in a surface and capacitive electrodes proximate thereto to provide a combined force and proximity sensor according to various examples. In the example of FIG. 14, display device 1400 can include active area 1405 for displaying graphical data and/or receiving touch inputs in accordance with the displayed data. The device 1400 can also include perimeter 1425 with dimple 1435 formed in the device cover glass at a particular perimeter location. The device 1400 can further have multiple capacitive electrodes 1450, 1455 disposed underneath the cover glass, where capacitive electrode 1450 can be directly beneath the dimple 1435 to form a combined force and proximity sensor and capacitive electrodes 1455 can be placed adjacent to and surrounding capacitive electrode 1450 to form additional force sensors.

The capacitive electrode 1450 can detect the seating of an object within the dimple via capacitance change in the same manner as the electrode of FIG. 3. The more seated the object within the dimple 1435, the greater the electrode self-capacitance increase. Thus, when a sensing circuit of the sensing device 1400 detects an increase in the self-capacitance of the electrode 1450, the increase can be interpreted as an object being proximate to the dimple 1435. A baseline capacitance can be established when there are no objects proximate to the dimple 1435 and can be compared to the capacitance when the object is seated in the dimple in order to determine the increase.

Concurrently therewith, the self-capacitance increase measured at the electrode 1450 can be used to detect the force applied by the object to the dimple 1435. Just as the electrode 1450 senses the object, the surrounding electrodes 1455 can also sense the object and have similar self-capacitance increases. The magnitude of the self-capacitance increase can be highest at the electrode closest to the object. In this example, the object is in the dimple 1435. As such, the self-capacitance increase of the electrode 1450 can be higher relative to the self-capacitance increases of the surrounding electrodes 1455. Thus, when a sensing circuit of the sensing device 1400 detects the self-capacitance increases, the increase pattern can be interpreted as a force being applied within the dimple 1435. On the other hand, when force is applied at another location, not the dimple, the resultant increase pattern can be interpreted to indicate a force at that other location. This patterning can be advantageously used to detect an accidental press on the device, i.e., a press outside the dimple 1435.

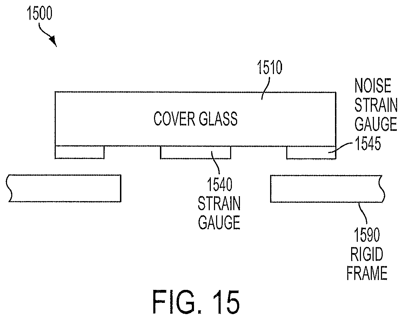

Force and proximity sensors can be susceptible to environmental factors, e.g., temperature changes, and operational factors, e.g., noise, that can affect the ability of the sensors to detect force and proximity. FIG. 15 illustrates an exemplary sensing device that can be used to reduce or eliminate such effects. The sensing device 1500 in FIG. 15 can be the same as the sensing device 600 in FIG. 6, with the addition of strain gauges 1545 to sense the effects of noise on the gauges, such that the noise can be compensated for in the force and proximity measurements made by strain gauge 1540. In the example of FIG. 15, strain gauge 1540 can sense force and proximity in the same manner as the gauge in FIG. 6. To prevent the other strain gauges 1545 from also stretching when the cover glass 1510 bows, rigid frame 1590 can be positioned beneath the gauges to hold them in place. As such, the gauges 1545 can continue to operate as if at rest and provide at-rest resistance data, indicative of device noise. The distance between the gauges can be set so that the noise sensing gauges 1545 are close enough to the force and proximity sensing gauge 1540 to experience the same noise, yet far enough away to avoid stretching when force is applied.

Accordingly, when the strain gauge 1540 detects a force and a proximity and transmits force and proximity measurements to a sensing circuit, the strain gauges 1545 can concurrently transmit their noise measurements to the circuit. The circuit can then apply any appropriate techniques using the two sets of measurements to compensate for noise.

In a similar manner, the strain gauges 1545 can be used to sense the effects of temperature on the gauges, such that the temperature effects can be compensated for in the force and proximity measurements made by strain gauge 1540.

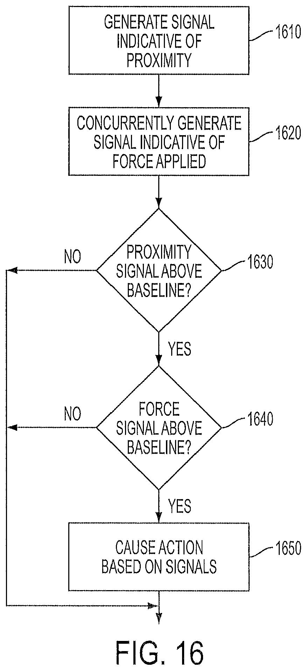

FIG. 16 illustrates an exemplary method for sensing combined force and proximity at a device according to various examples. In the example of FIG. 16, a signal indicative of a proximity of an object to the device can be generated (1610). In some examples, the signal can be generated by either a resistive sensor or a capacitive sensor via a capacitance change at the sensor. For example, the closer the object is to the device, the greater the capacitance change. Concurrently therewith, a signal indicative of force applied by the object to the device can also be generated (1620). In some examples, the signal can be generated by a resistive sensor via a resistance change at the sensor. For example, the object's applied force can cause the device's surface to slightly bow and the underlying resistive sensor to correspondingly deform. The more force applied to the device, the greater the resistance change. In some examples, the signal can be generated by a capacitive sensor via a capacitance change at the sensor. For example, the object's applied force can cause the device's surface to slightly bow and the underlying capacitive sensor to correspondingly deform. The more force applied to the device, the greater the capacitance change.

A determination can be made whether the proximity signal measures above a baseline by a first proximity threshold (1630). In some examples, the first proximity threshold can be fixed as a percentage of full scale as determined during calibration, e.g., at the factory. If the signal is above the baseline by the first proximity threshold, the signal can be considered true. On the other hand, if the signal is below the baseline by a second proximity threshold, the signal can be deemed false and discarded. In some examples, the second proximity threshold can be fixed as a product of the first fixed threshold multiplied by a hysteresis factor. As such, a false proximity signal can be sufficiently different from a true proximity signal so as to avoid cycling between the two because of variation in the object's pressure or position during a touch or hover.

A similar determination can be made whether the force signal measures above a baseline by a first force threshold (1640). If the force signal is above the baseline by the first force threshold, the signal can be considered true. If the signal is below the baseline by a second force threshold, the signal can be deemed false and discarded. In some examples, the force thresholds can be fixed to correspond to a given number of grams, as determined during calibration, e.g., at the factory, by using a linear transformation on the force signal.

An action can then be performed by the device based on the true proximity signal and the true force signal (1650).

In some examples, the proximity and force baselines can be set at fixed values at the factory or by the user. Alternatively, the baselines can be computed continuously during operation with an adaptive algorithm, for example, which can track slow changes in the proximity and/or force sensors due to temperature, mechanical fatigue, humidity and other drift factors. Here, the baselines can be computed from the sensor signals with a filter having a variable time constant, e.g., an IIR filter, an FIR filter, or some other type of memoryless exponential smoothing filter.

The baselines can be updated with the computed baseline values whenever the sensor signals drop below current baseline values. The variable time constant can be temporarily reset so that the updating can be done quickly, e.g., when a baseline is high upon device wake-up. In some examples, the baseline for the proximity sensor can be updated whenever the difference between the proximity signal and the baseline is less than a predetermined threshold. In some examples, the predetermined threshold can be computed from a proximity sensor measurement taken when no object is proximate to the sensor. In some examples, the baseline for the force sensor can be similarly updated, where its predetermined threshold can be computed from a force sensor measurement taken when no object is applying force.

In some examples, the proximity and force signals can be filtered to remove impulsive and random noise using one or more filters, e.g., median filters, running average filters, and the like. This can help reduce sensor and device noise effects and baseline corruption.

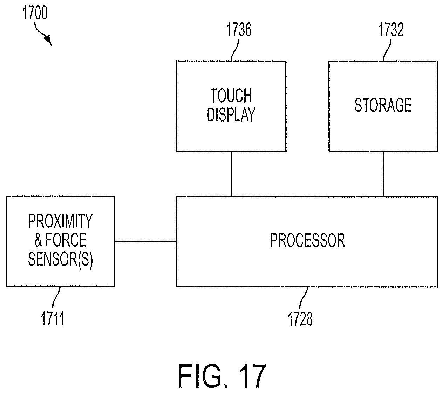

FIG. 17 illustrates an exemplary computing system for sensing combined force and proximity according to various examples. In the example of FIG. 17, computing system 1700 can include force and proximity sensor(s) 1711 for sensing a force applied by an object on a surface and a proximity of the object to the surface. The system 1700 can also include processor 1728 for receiving outputs from the sensor(s) 1711 and performing actions based on the outputs that can include, but are not limited to, returning to a home display, waking up a device, moving an object such as a cursor or pointer, scrolling or panning, adjusting control settings, opening a file or document, viewing a menu, making a selection, executing instructions, operating a peripheral device coupled to the host device, answering a telephone call, placing a telephone call, terminating a telephone call, changing the volume or audio settings, storing information related to telephone communications such as addresses, frequently dialed numbers, received calls, missed calls, logging onto a computer or a computer network, permitting authorized individuals access to restricted areas of the computer or computer network, loading a user profile associated with a user's preferred arrangement of the computer desktop, permitting access to web content, launching a particular program, encrypting or decoding a message, and/or the like. The processor 1728 can also perform additional functions that may not be related to force and proximity sensing, and can be connected to program storage 1732 and touch sensitive display 1736. Display 1736 can include an LCD for providing a user interface to a user of the display and a touch panel for sensing a touch or hover at the display.

Note that one or more of the actions described above, can be performed, for example, by firmware stored in memory or stored in the program storage 1732 and executed by the processor 1728. The firmware can also be stored and/or transported within any non-transitory computer readable storage medium for use by or in connection with an instruction execution system, apparatus, or device, such as a computer-based system, processor-containing system, or other system that can fetch the instructions from the instruction execution system, apparatus, or device and execute the instructions. In the context of this document, a "non-transitory computer readable storage medium" can be any medium that can contain or store the program for use by or in connection with the instruction execution system, apparatus, or device. The non-transitory computer readable storage medium can include, but is not limited to, an electronic, magnetic, optical, electromagnetic, infrared, or semiconductor system, apparatus or device, a portable computer diskette (magnetic), a random access memory (RAM) (magnetic), a read-only memory (ROM) (magnetic), an erasable programmable read-only memory (EPROM) (magnetic), a portable optical disc such a CD, CD-R, CD-RW, DVD, DVD-R, or DVD-RW, or flash memory such as compact flash cards, secured digital cards, USB memory devices, memory sticks, and the like.

The firmware can also be propagated within any transport medium for use by or in connection with an instruction execution system, apparatus, or device, such as a computer-based system, processor-containing system, or other system that can fetch the instructions from the instruction execution system, apparatus, or device and execute the instructions. In the context of this document, a "transport medium" can be any medium that can communicate, propagate or transport the program for use by or in connection with the instruction execution system, apparatus, or device. The transport readable medium can include, but is not limited to, an electronic, magnetic, optical, electromagnetic or infrared wired or wireless propagation medium.

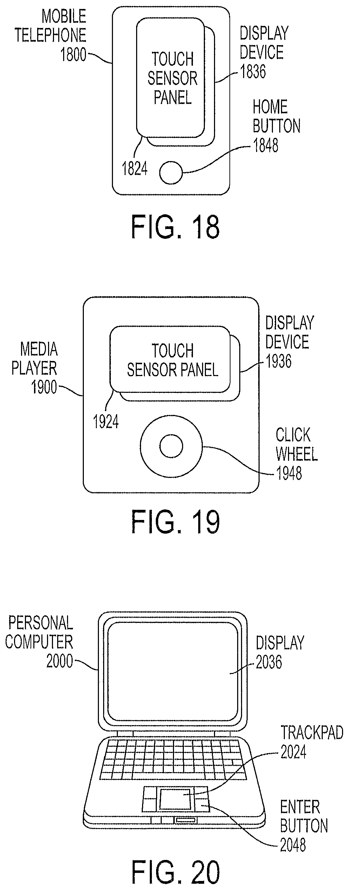

FIG. 18 illustrates an exemplary mobile telephone 1800 that can include home button 1848 having combined force and proximity sensor(s) capable of operating on touch panel 1824, display device 1836, and other computing system blocks according to various examples.

FIG. 19 illustrates an exemplary digital media player 1900 that can include clickwheel 1948 having combined force and proximity sensor(s) capable of operating on touch panel 1924, display device 1936, and other computing system blocks according to various examples.

FIG. 20 illustrates an exemplary personal computer 2000 that can include enter buttons 2048 having combined force and proximity sensor(s) capable of operating on touch pad 2024, display 2036, and other computing system blocks according to various examples.

The mobile telephone, media player, and personal computer of FIGs. 18 through 20 can reduce or eliminate accidental operations thereon using combined force and proximity sensing according to various examples.

Therefore, according to the above, some examples of the disclosure are directed to a combined force and proximity sensing device comprising one or more of: a first sensor configured to detect a proximity of an object to the device; a second sensor configured to detect a force applied by the object to the device; and a flexible circuit including the first sensor therein and proximate to the second sensor. Additionally or alternatively to one or more of the examples disclosed above, in some examples the first and second sensors detect the respective proximity and force concurrently. Additionally or alternatively to one or more of the examples disclosed above, in some examples the first sensor comprises a capacitive sensor and the second sensor comprises a resistive sensor, and wherein the first and second sensors are stacked together. Additionally or alternatively to one or more of the examples disclosed above, in some examples the first sensor comprises a capacitive sensor and the second sensor comprises a resistive sensor, and wherein the first and second sensors are positioned side by side. Additionally or alternatively to one or more of the examples disclosed above, in some examples a first element of the second sensor is disposed on the flexible circuit, the first sensor comprising a first capacitive electrode and the first element of the second sensor comprising a second capacitive electrode, the device comprising one or more of a conductive member coupled to the flexible circuit and forming a second element of the second sensor; and multiple spacers disposed between the flexible circuit and the conductive member to couple the circuit and the member together, forming a gap therebetween. Additionally or alternatively to one or more of the examples disclosed above, in some examples the conductive member is rigid. Additionally or alternatively to one or more of the examples disclosed above, in some examples the conductive member comprises a rigid portion proximate to the first element of the second sensor and flexible portions coupled to the spacers. Additionally or alternatively to one or more of the examples disclosed above, some examples include a sealant applied to open edges of the flexible circuit and the conductive member to seal the gap. Additionally or alternatively to one or more of the examples disclosed above, in some examples the gap is filled with dielectric material. Additionally or alternatively to one or more of the examples disclosed above, in some examples a first element of the second sensor is disposed on the flexible circuit, the first sensor comprising a first capacitive electrode and the first element of the second sensor comprising a second capacitive electrode, the device comprising one or more of a third capacitive electrode disposed proximate to the first element of the second sensor and forming a second element of the second sensor, wherein a gap is formed between the first and second elements of the second sensor. Additionally or alternatively to one or more of the examples disclosed above, in some examples a first element of the second sensor is disposed on the flexible circuit, the device comprising one or more of a second flexible circuit coupled to the flexible circuit and including a second element of the second sensor therein, wherein the first sensor and the first and second elements are capacitive electrodes and a gap is formed between the flexible circuits. Additionally or alternatively to one or more of the examples disclosed above, in some examples the first sensor forms a first element of the second sensor, the device comprising a second capacitive electrode disposed proximate to the first sensor and forming a second element of the second sensor, wherein a gap is formed between the first and second elements of the second sensor.

Some examples of the disclosure are directed to a combined force and proximity sensing device comprising: a sensor configured to generate a first signal indicative of a proximity of an object to the device and a second signal indicative of a force applied by the object to the device. Additionally or alternatively to one or more of the examples disclosed above, in some examples the sensor generating the first and second signals together. Additionally or alternatively to one or more of the examples disclosed above, in some examples the sensor comprises a resistive sensor having multiple traces, the traces configured to lengthen and narrow when the force is applied in order to sense the force and to capacitively couple in order to sense the object proximity. Additionally or alternatively to one or more of the examples disclosed above, in some examples the device is incorporated into at least one of a mobile telephone, a digital media player, or a portable computer.

Some examples of the disclosure are directed to an apparatus for combined force and proximity sensing comprising one or more of a substrate having a touchable surface; a sensing device proximate to the substrate including one or more of a first sensor configured to generate a first signal indicative of a proximity of an object to the touchable surface, the first sensor disposed within a flexible circuit, and at least one second sensor configured to concurrently generate a second signal indicative of a force applied by the object to the touchable surface; and a processor configured to process the first and second signals and to perform an action based thereon. Additionally or alternatively to one or more of the examples disclosed above, in some examples at least one set of conductive traces are selectably coupled to the first and second sensors for transmitting the first and second signals to the processor.

Some examples of the disclosure are directed to an apparatus for combined force and proximity sensing comprising one or more of a substrate having a touchable surface; a sensing device proximate to the substrate including a sensor configured to detect together a proximity of an object to the touchable surface and a force applied by the object to the touchable surface; and a processor configured to process a first signal indicative of the detected proximity and a second signal indicative of the detected force and to perform an action based thereon. Additionally or alternatively to one or more of the examples disclosed above, in some examples the sensing device includes a second sensor configured to detect at least one of a temperature effect or a noise at the apparatus, and wherein the processor is configured to compensate at least one of the first signal or the second signal for at least one of the detected temperature effect or the noise. Additionally or alternatively to one or more of the examples disclosed above, in some examples the substrate has a dimple in the touchable surface for receiving the object therein, wherein the sensor detects a seating of the object within the dimple and the force applied by the object within the dimple, wherein the sensing device includes multiple sensors surrounding the sensor and proximate to the dimple to detect the force, and wherein the processor is configured to process third signals indicative of the force detected by the multiple sensors and to determine a location relative to the dimple where the force is applied based on the second and third signals. Additionally or alternatively to one or more of the examples disclosed above, in some examples the sensing device includes multiple sensors disposed around a perimeter of the substrate to detect the force, and wherein the processor is configured to process third signals indicative of the force detected by the multiple sensors and to determine, based on the second and third signals, the touchable surface location at which the force is applied from among multiple possible touchable surface locations.

Some examples of the disclosure are directed to a method for combined force and proximity sensing at a substantially rigid substrate, the method comprising one or more of sensing a force applied by an object to a surface of the substrate, the substrate slightly deforming in response to the applied force; concurrently sensing a proximity of the object to the surface; and performing an action based on the sensed force and the sensed proximity. Additionally or alternatively to one or more of the examples disclosed above, in some examples sensing a force comprises one or more of deforming a resistive sensor configured to sense the force in association with the deforming of the substrate; and measuring a change in resistance due to the sensor deformation, the resistance change indicating the force applied. Additionally or alternatively to one or more of the examples disclosed above, in some examples sensing a force comprises one or more of changing a distance between capacitive elements of a sensor configured to sense the force in association with the deforming of the substrate; and measuring a change in capacitance due to the change in distance, the capacitance change indicating the force applied. Additionally or alternatively to one or more of the examples disclosed above, in some examples sensing proximity comprises: measuring a change in capacitance of a capacitive sensor configured to sense the proximity, the capacitance change indicating the proximity. Additionally or alternatively to one or more of the examples disclosed above, some examples include one or more of determining whether the sensed force and the sensed proximity exceed corresponding baseline values; and if so, performing the action, otherwise, skipping the action.

Although examples have been fully described with reference to the accompanying drawings, it is to be noted that various changes and modifications will become apparent to those skilled in the art. Such changes and modifications are to be understood as being included within the scope of the various examples as defined by the appended claims.

## Claims

1. A combined force and proximity sensing device (300) comprising:
a first sensor (330) configured to detect a proximity of an object to the device (300) ;
a second sensor (320) configured to detect a force applied by the object to the device (300); and
a flexible circuit (340) including the first sensor (330) therein and wherein the first sensor (330) is proximate to the second sensor,
wherein the second sensor is disposed on a surface of the flexible circuit (340) the device being **characterised in that**
the second sensor comprises a strain gauge (520) including a conductive trace (525) configured to bow into a gap when force is applied by the object to the device (300), wherein the conductive trace is configured to detect the force applied by the object to the device (300) based on the bowing concurrently with the first sensor (330) detecting the proximity of the object to the device.

2. The device of claim 1, wherein the first sensor comprises a capacitive sensor and the second sensor comprises a resistive sensor, and wherein the first and second sensors are stacked together.

3. The device of claim 1, wherein the first sensor comprises a capacitive sensor and the second sensor comprises a resistive sensor, and wherein the first and second sensors are positioned side by side.

4. The device of claim 1, wherein a first element of the second sensor is disposed on the flexible circuit, the first sensor comprising a first capacitive electrode and the first element of the second sensor comprising a second capacitive electrode, the device comprising:
a conductive member coupled to the flexible circuit and forming a second element of the second sensor; and
multiple spacers disposed between the flexible circuit and the conductive member to couple the circuit and the member together, forming a gap therebetween.

5. The device of claim 4, wherein the conductive member comprises a rigid portion proximate to the first element of the second sensor and flexible portions coupled to the spacers.

6. The device of claim 1, wherein a first element of the second sensor is disposed on the flexible circuit, the first sensor comprising a first capacitive electrode and the first element of the second sensor comprising a second capacitive electrode, the device comprising:
a third capacitive electrode disposed proximate to the first element of the second sensor and forming a second element of the second sensor,
wherein a gap is formed between the first and second elements of the second sensor.

7. The device of claim 1, where a first element of the second sensor is disposed on the flexible circuit, the device comprising:
a second flexible circuit coupled to the flexible circuit and including a second element of the second sensor therein,
wherein the first sensor and the first and second elements are capacitive electrodes and a gap is formed between the flexible circuits.

8. The device of claim 1, wherein the first sensor forms a first element of the second sensor, the device comprising:
a second capacitive electrode disposed proximate to the first sensor and forming a second element of the second sensor,
wherein a gap is formed between the first and second elements of the second sensor.

9. The device of claim 1, further comprising:
a substrate proximate to the device and having a touchable surface;
wherein the first sensor is configured to generate a first signal indicative of the proximity of the object to the touchable surface, and
wherein the second sensor is configured to generate a second signal indicative of the force applied by the object to the touchable surface; and
further comprising a processor configured to process the first and second signals and to perform an action based thereon.

10. The apparatus of claim 9, comprising:
at least one set of conductive traces selectably coupled to the first and second sensors for transmitting the first and second signals to the processor.

11. A method for combined force and proximity sensing at a substantially rigid substrate of a device according to claim 1, the method comprising:
sensing, by the second sensor, a force applied by an object to a surface of the substrate, the substrate slightly deforming in response to the applied force;
concurrently sensing, by the first sensor, a proximity of the object to the surface with sensing the force applied by the object to the surface; and
performing an action based on the sensed force and the sensed proximity.

12. The method of claim 11, wherein sensing a force comprises:
deforming a resistive sensor configured to sense the force in association with the deforming of the substrate; and
measuring a change in resistance due to the sensor deformation, the resistance change indicating the force applied.

13. The method of claim 11, wherein sensing a force comprises:
changing a distance between capacitive elements of a sensor configured to sense the force in association with the deforming of the substrate; and
measuring a change in capacitance due to the change in distance, the capacitance change indicating the force applied.

14. The method of claim 11, wherein sensing a proximity comprises:
measuring a change in capacitance of a capacitive sensor configured to sense the proximity, the capacitance change indicating the proximity.

15. The method of claim 11, comprising:
determining whether the sensed force and the sensed proximity exceed corresponding baseline values; and
if so, performing the action, otherwise, skipping the action.

## Patentansprüche

1. Kombinierte Kraft- und Näherungssensorvorrichtung (300), umfassend:
einen ersten Sensor (330), der konfiguriert ist, um eine Nähe eines Objekts zu der Vorrichtung (300) zu erfassen;
einen zweiten Sensor (320), der konfiguriert ist, um eine vom Objekt auf die Vorrichtung (300) ausgeübte Kraft zu erfassen; und
eine flexible Schaltung (340), die den ersten Sensor (330) darin beinhaltet und wobei der erste Sensor (330) in der Nähe des zweiten Sensors liegt,
wobei der zweite Sensor auf einer Oberfläche der flexiblen Schaltung (340) angeordnet ist, wobei die Vorrichtung **dadurch gekennzeichnet ist, dass** der zweite Sensor einen Dehnungsmessstreifen (520) mit einer leitenden Spur (525) umfasst, der konfiguriert ist, um sich in einen Spalt zu beugen, wenn eine Kraft durch das Objekt auf die Vorrichtung (300) ausgeübt wird, wobei die leitende Spur konfiguriert ist, um die Kraft, die durch das Objekt auf die Vorrichtung (300) ausgeübt wird basierend auf der Beugung gleichzeitig mit dem ersten Sensor (330), der die Nähe des Objekts zu der Vorrichtung erfasst, zu erfassen.

2. Vorrichtung nach Anspruch 1, wobei der erste Sensor einen kapazitiven Sensor und der zweite Sensor einen resistiven Sensor umfasst, und wobei der erste und der zweite Sensor zusammengeschichtet sind.

3. Vorrichtung nach Anspruch 1, wobei der erste Sensor einen kapazitiven Sensor und der zweite Sensor einen resistiven Sensor umfasst, und wobei der erste und der zweite Sensor nebeneinander angeordnet sind.

4. Vorrichtung nach Anspruch 1, wobei ein erstes Element des zweiten Sensors auf der flexiblen Schaltung angeordnet ist, wobei der erste Sensor eine erste kapazitive Elektrode und das erste Element des zweiten Sensors eine zweite kapazitive Elektrode umfasst, wobei die Vorrichtung umfasst:
ein leitfähiges Element, das mit der flexiblen Schaltung gekoppelt ist und ein zweites Element des zweiten Sensors bildet; und
mehrere Abstandshalter, die zwischen der flexiblen Schaltung und dem leitenden Element angeordnet sind, um die Schaltung und das Element miteinander zu verbinden und einen Spalt dazwischen zu bilden.

5. Vorrichtung nach Anspruch 4, wobei das leitende Element einen starren Abschnitt in der Nähe des ersten Elements des zweiten Sensors und flexible Abschnitte, die mit den Abstandshaltern gekoppelt sind, umfasst.

6. Vorrichtung nach Anspruch 1, wobei ein erstes Element des zweiten Sensors auf der flexiblen Schaltung angeordnet ist, wobei der erste Sensor eine erste kapazitive Elektrode und das erste Element des zweiten Sensors eine zweite kapazitive Elektrode umfasst, wobei die Vorrichtung umfasst:
eine dritte kapazitive Elektrode, die in der Nähe des ersten Elements des zweiten Sensors angeordnet ist und ein zweites Element des zweiten Sensors bildet, wobei ein Spalt zwischen dem ersten und zweiten Element des zweiten Sensors gebildet wird.

7. Vorrichtung nach Anspruch 1, wobei ein erstes Element des zweiten Sensors auf der flexiblen Schaltung angeordnet ist, wobei die Vorrichtung umfasst:
eine zweite flexible Schaltung, die mit der flexiblen Schaltung gekoppelt ist und ein zweites Element des zweiten Sensors darin beinhaltet,
wobei der erste Sensor und das erste und zweite Element kapazitive Elektroden sind und ein Spalt zwischen den flexiblen Schaltungen gebildet wird.

8. Vorrichtung nach Anspruch 1, wobei der erste Sensor ein erstes Element des zweiten Sensors bildet, wobei die Vorrichtung umfasst:
eine zweite kapazitive Elektrode, die in der Nähe des ersten Sensors angeordnet ist und ein zweites Element des zweiten Sensors bildet,
wobei ein Spalt zwischen dem ersten und zweiten Element des zweiten Sensors gebildet wird.

9. Vorrichtung nach Anspruch 1, ferner umfassend:
ein Substrat in der Nähe der Vorrichtung und mit einer berührbaren Oberfläche;
wobei der erste Sensor konfiguriert ist, um ein erstes Signal zu erzeugen, das die Nähe des Objekts zu der berührbaren Oberfläche anzeigt, und
wobei der zweite Sensor konfiguriert ist, um ein zweites Signal zu erzeugen, das die Kraft, die das Objekt auf die berührbare Oberfläche ausübt, anzeigt; und
ferner umfassend einen Prozessor, der konfiguriert ist, um das erste und zweite Signal zu verarbeiten und eine darauf basierende Aktion auszuführen.

10. Vorrichtung nach Anspruch 9, umfassend:
mindestens einen Satz von Leiterbahnen, die selektiv mit dem ersten und zweiten Sensor gekoppelt sind, um das erste und zweite Signal an den Prozessor zu übertragen.

11. Verfahren zum kombinierten Erfassen von Kraft und Nähe an einem im Wesentlichen starren Substrat einer Vorrichtung nach Anspruch 1, wobei das Verfahren umfasst:
Erfassen, durch den zweiten Sensor, einer von einem Objekt auf eine Oberfläche des Substrats ausgeübten Kraft, wobei sich das Substrat in Antwort auf die ausgeübte Kraft leicht verformt;
gleichzeitiges Erfassen, durch den ersten Sensor, einer Nähe des Objekts zu der Oberfläche mit dem Erfassen der von dem Objekt auf die Oberfläche ausgeübten Kraft; und
Ausführen einer Aktion basierend auf der erfassten Kraft und der erfassten Nähe.

12. Verfahren nach Anspruch 11, wobei das Erfassen einer Kraft umfasst:
Verformen eines resistiven Sensors, der konfiguriert ist, um die Kraft in Verbindung mit der Verformung des Substrats zu erfassen; und
Messen einer Widerstandsänderung aufgrund der Sensorverformung, wobei die Widerstandsänderung die ausgeübte Kraft anzeigt.

13. Verfahren nach Anspruch 11, wobei das Erfassen einer Kraft umfasst:
Ändern eines Abstands zwischen kapazitiven Elementen eines Sensors, der konfiguriert ist, um die Kraft in Verbindung mit der Verformung des Substrats zu erfassen; und
Messen einer Kapazitätsänderung aufgrund der Abstandsänderung, wobei die Kapazitätsänderung die ausgeübte Kraft anzeigt.

14. Verfahren nach Anspruch 11, wobei das Erfassen einer Nähe umfasst:
Messen einer Kapazitätsänderung eines kapazitiven Sensors, der konfiguriert ist, um die Nähe zu erfassen, wobei die Kapazitätsänderung die Nähe anzeigt.

15. Verfahren nach Anspruch 11, umfassend:
Bestimmen, ob die erfasste Kraft und die erfasste Nähe entsprechende Basiswerte überschreiten; und
wenn ja, Durchführen der Aktion, ansonsten Überspringen der Aktion.

## Revendications

1. Un dispositif de détection combinée de force et de proximité (300) comprenant :
un premier capteur (330) configuré pour détecter une proximité d'un objet d'avec le dispositif (300) ;
un second capteur (320) configuré pour détecter une force appliquée par l'objet au dispositif (300) ; et
un circuit flexible (340) comprenant dedans le premier capteur (330) et dans lequel le premier capteur (330) à proximité du second capteur,
dans lequel le second capteur est disposé sur une surface du circuit flexible (340),
le dispositif étant **caractérisé en ce que**
le second capteur comprend une jauge de contrainte (520) comprenant une piste conductrice (525) configurée pour se courber dans un intervalle lorsqu'une force est appliquée par l'objet au dispositif (300), la piste conductrice étant configurée pour détecter la force appliquée par l'objet au dispositif (300) sur la base de la courbure, en même temps que le premier capteur (330) détecte la proximité de l'objet d'avec le dispositif.

2. Le dispositif de la revendication 1, dans lequel le premier capteur comprend un capteur capacitif et le second capteur comprend un capteur résistif, et dans lequel le premier et le second capteur sont empilés l'un sur l'autre.

3. Le dispositif de la revendication 1, dans lequel le premier capteur comprend un capteur capacitif et le second capteur comprend un capteur résistif, et dans lequel le premier et le second capteur sont placés côte à côte.

4. Le dispositif de la revendication 1, dans lequel un premier élément du second capteur est disposé sur le circuit flexible, le premier capteur comprenant une première électrode capacitive et le premier élément du second capteur comprenant une seconde électrode capacitive, le dispositif comprenant :
un organe conducteur couplé au circuit flexible et formant un second élément du second capteur ; et
des entretoises multiples disposées entre le circuit flexible et l'organe conducteur pour coupler ensemble le circuit et l'organe, en formant entre eux un intervalle.

5. Le dispositif de la revendication 4, dans lequel l'organe conducteur comprend une partie rigide à proximité du premier élément du second capteur et des parties flexibles couplées aux entretoises.

6. Le dispositif de la revendication 1, dans lequel un premier élément du second capteur est disposé sur le circuit flexible, le premier capteur comprenant une première électrode capacitive et le premier élément du second capteur comprenant une seconde électrode capacitive, le dispositif comprenant :
une troisième électrode capacitive disposée à proximité du premier élément du second capteur et formant un second élément du second capteur,
un intervalle étant formé entre le premier et le second élément du second capteur.

7. Le dispositif de la revendication 1, dans lequel un premier élément du second capteur est disposé sur le circuit flexible, le dispositif comprenant :
un second circuit flexible couplé au circuit flexible et comprenant dedans un second élément du second capteur,
le premier capteur et le premier et le second élément étant des électrodes capacitives et un intervalle étant formé entre les circuits flexibles.

8. Le dispositif de la revendication 1, dans lequel le premier capteur forme un premier élément du second capteur, le dispositif comprenant :
une seconde électrode capacitive disposée à proximité du premier capteur et formant un second élément du second capteur,
un intervalle étant formé entre le premier et le second élément du second capteur.

9. Le dispositif de la revendication 1, comprenant en outre :
un substrat à proximité du dispositif et comportant une surface qui peut être touchée ;
dans lequel le premier capteur est configuré pour générer un premier signal représentatif de la proximité de l'objet avec la surface qui peut être touchée, et
dans lequel le second capteur est configuré pour générer un second signal représentatif de la force appliquée par l'objet à la surface qui peut être touchée ; et
comprenant en outre un processeur configuré pour traiter le premier et le second signal et pour exécuter une action en fonction de ceux-ci.

10. L'appareil de la revendication 9, comprenant :
au moins un ensemble de pistes conductrices sélectivement couplées au premier et au second capteur pour transmettre au processeur le premier et le second signal.

11. Un procédé de détection combinée de force et de proximité au niveau d'un substrat substantiellement rigide d'un dispositif selon la revendication 1, le procédé comprenant :
la détection, par le second capteur, d'une force appliquée par un objet à une surface du substrat, le substrat se déformant légèrement en réponse à la force appliquée ;
la détection concomitante, par le premier capteur, d'une proximité de l'objet avec la surface tout en détectant la force appliquée par l'objet à la surface ; et
l'exécution d'une action en fonction de la force détectée et de la proximité détectée.

12. Le procédé de la revendication 11, dans lequel la détection d'une force comprend :
la déformation d'un capteur résistif configuré pour détecter la force en combinaison avec la déformation du substrat ; et
les mesures d'une variation de résistance due à la déformation du capteur, la variation de résistance indiquant la force appliquée.

13. Le procédé de la revendication 11, dans lequel la détection d'une force comprend :
la variation d'une distance entre des éléments capacitifs d'un capteur configuré pour détecter la force en combinaison avec la déformation du substrat ; et
la mesure d'une variation de capacité due à la variation de distance, la variation de capacité indiquant la force appliquée.

14. Le procédé de la revendication 11, dans lequel la détection d'une proximité comprend :
la mesure d'une variation de capacité d'un capteur capacitif configuré pour détecter la proximité, la variation de capacité indiquant la proximité.

15. Le procédé de la revendication 11, comprenant :
la détermination si la force détectée et la proximité détectée dépassent ou non des valeurs de référence correspondantes ; et
dans l'affirmative l'exécution de l'action, dans le cas contraire l'omission de l'action.
